# EUROPEAN PATENT APPLICATION

(11) **EP 1 863 126 A1**
(43) Date of publication of application: **05.12.2007**
(21) Application number: 05721176.5
(22) Date of filing: 18.03.2005
(51) Int. Cl.: H01Q 19/10, H01Q 9/14, H04B 5/02

(54) **RFID TAG**

(71) Applicant: FUJITSU LIMITED, Nakahara-ku Kawasaki-shi Kanagawa 211-8588 (JP)
(72) Inventor: FURUTANI, Nagahisa, FUJITSU LIMITED, Kawasaki-shi, Kanagawa 211-8588 (JP)
(74) Representative: Cooper-Rolfe, Elizabeth Louise
(86) International application number: PCT/JP2005/005026
(87) International publication number: WO 2006/100742

(57) **Abstract**

A radio frequency identification tag (11) allows embedment of antenna wires (14a, 14b) within a thin plate (12) made of a resin material. The antenna wires (14a, 14b) forms a dipole antenna, for example. Radio wave reflectors (15a, 15b, 15c, 15d) made of metal are also embedded in the thin plate (12) in parallel with the antenna wires (14a, 14b). The radio wave reflectors (15a, 15b, 15c, 15d) reflect radio wave penetrating into the thin plate (12). The reflected radio wave is directed to the antenna wires (14a, 14b). The antenna wires (14a, 14b) receives radio wave of an increased amount. The tag significantly contributes to increase in a communication range. Since the radio wave reflectors (15a, 15b, 15c, 15d) are embedded in the thin plate (12), the tag can be utilized in conventional purposes. The addition of a reflector outside the tag inevitably restrains the application of the tag.

## Description

### FIELD OF THE INVENTION

The present invention relates to a radio frequency identification (RFID) tag.

### BACKGROUND ART

A radio frequency identification tag is well known. In general, the radio frequency identification tag includes a dipole antenna. The dipole antenna includes an antenna wire corresponding to a length specified by λ/2. The radio frequency identification tag can transmit/receive predetermined radio signals through such an antenna wire.

A strong intensity transmission power for the radio signals enables establishment of a sufficient quality radio communication between the radio frequency identification tags and the radio signal source, even when the radio frequency identification tags are distanced from the radio signal source. The maximum transmission power, however, is legally restrained. Accordingly, a technique is required to increase the communication range between the source of the radio signal and the radio frequency identification tags without increasing the transmission power of radio signals as disclosed in United States Patent No. 6,441,740, for example.
Patent Publication 1: United States Patent No. 6,441,740
Patent Publication 2: United States Patent No. 6,535,175

### DISCLOSURE OF THE INVENTION

It is accordingly an object of the present invention to provide a radio frequency identification tag contributing to an increased communication range without increasing the transmission power of radio signals.

According to the present invention, there is provided a radio frequency identification tag comprising: a thin plate made of a resin material; an antenna wire embedded in the thin plate; and a radio wave reflector made of a metallic material embedded in the thin plate, the radio wave reflector extending in parallel with the antenna wire.

The radio wave reflector serves to reflect radio wave penetrating into the thin plate in the radio frequency identification tag. The reflected radio wave is directed to the antenna wire. The radio wave reflector serves to increase the received amount of the radio wave at the antenna wire. The radio frequency identification tag thus significantly contributes to increase of a communication range. Moreover, since the radio wave reflector is embedded in the thin plate, the radio frequency identification tag can be utilized in conventional applications or purposes as ever. In the case where the reflector is addedoutside the radio frequency identification tag, the radio frequency identification tag can be used in a considerably limited applications or purposes.

The antenna wire may form a dipole antenna or a folded dipole antenna. Such an antenna includes an antenna wire corresponding to the length specified by λ/2. The radio frequency identification tag is allowed to receive/transmit predetermined radio signals by means of the antenna wire.

The radio wave reflector may include elongated members spaced from each other, the elongated members each defining a flat surface inclined by a predetermined inclination angle around an axis parallel to the antenna wire. The flat surfaces realize the reflection of the radio wave. The flat surfaces serve to direct the radio wave to the antenna wire.

The elongated members may include: a first elongated member set comprising first elongated members disposed along the front surface of the thin plate, the first elongated members each having the end remoter from the antenna wire and located closer to the back surface of the thin plate; and a second elongated member set comprising second elongated members disposed along the back surface of the thin plate, the second elongated members each having the end remoter from the antenna wire and located closer to the front surface of the thin plate. The flat surfaces of the second elongated members serve to reflect radio wave penetrating into the front surface of the thin plate in the radio frequency identification tag. The reflected radio wave is directed to the antenna wire. The flat surfaces of the first elongated members likewise serve to reflect radio wave penetrating into the back surface of the thin plate. The reflected radio wave is directed to the antenna wire. The radio wave reflector serves to increase the received amount of the radio wave in the opposite directions at the antenna wire.

Alternatively, the elongatedmembers include an elongated member set comprising specific elongated members disposed along the back surface of the thin plate, the specific elongatedmembers each having the end remoter from the antenna wire and located closer to the front surface of the thin plate. A metal shielding plate may be bonded to the back surface of the thin plate in the radio frequency identification tag, for example. The radio frequency identification tag allows the antenna wire to always receive radio wave of a sufficient intensity whatever contacts with the back surface of the thin plate.

The radio wave reflector may include elongated members spaced from each other, the elongated members each defining a semicylindrical surface having generatrix parallel to the antenna wire. The semicylindrical surfaces realize the reflection of the radio wave. The semicylindrical surfaces serve to direct the radio wave to the antenna wire.

The elongated members may include: a first elongated member set comprising first elongated members disposed along the front surface of the thin plate, the first elongated members each defining a semicylindrical surface opposed to the back surface of the thin plate; and a second elongated member set comprising second elongated members disposed along the back surface of the thin plate, the second elongated members each defining a semicylindrical surface opposed to the front surface of the thin plate. The semicylindrical surfaces of the second elongated members serve to reflect radio wave penetrating into the front surface of the thin plate in the radio frequency identification tag. The reflected radio wave is directed to the antenna wire. The semicylindrical surfaces of the first elongated members likewise serve to reflect radio wave penetrating into the back surface of the thin plate. The reflected radio wave is directed to the antenna wire. The radio wave reflector serves to increase the received amount of the radio wave in the opposite directions at the antenna wire.

Alternatively, the elongated members may include an elongated member set comprising specific elongated members disposed along the front surface of the thin plate, the specific elongated members each defining a semicylindrical surface opposed to the back surface of the thin plate. A metal shielding plate may be bonded to the back surface of the thin plate in the radio frequency identification tag, for example. The radio frequency identification tag allows the antenna wire to always receive radio wave of a sufficient intensity whatever contacts with the back surface of the thin plate.

The radio wave reflector may include elongated members spaced from each other, the elongated members each defining a cylindrical surface having generatrix parallel to the antenna wire. The radio wave reflector may include elongated members each defining domed surfaces arranged in parallel with the antenna wire.

### BRIEF DESCRIPTION OF THE DRAWINGS

Fig.1 is a plan view schematically illustrating a radio frequency identification tag (RFID) according to a first embodiment of the present invention.
Fig. 2 is an enlarged partial sectional view, taken along the line 2-2 in Fig. 1, of the radio frequency identification tag.
Fig. 3 is an enlarged sectional view, taken along the line 3-3 in Fig. 1, of the Radio frequency identification tag.
Fig. 4 is a plan view of a metal thin film for schematically illustrating the process of making the radio frequency identification tag.
Fig. 5 is an enlarged sectional view, corresponding to Fig. 3, of a radio frequency identification tag according to a modification of the first embodiment.
Fig. 6 is an enlarged sectional view, corresponding to Fig. 3, of a radio frequency identification tag according to another modification of the first embodiment.
Fig. 7 is an enlarged partial perspective view schematically illustrating domed surfaces defined on an elongated member.
Fig. 8 is an enlarged sectional view, corresponding to Fig. 3, of a radio frequency identification tag according to still another modification of the first embodiment.
Fig. 9 is an enlarged sectional view, corresponding to Fig. 3, of a radio frequency identification tag according to a second embodiment of the present invention.
Fig. 10 is an enlarged sectional view, corresponding to Fig. 3, of a radio frequency identification tag according to a modification of the second embodiment.
Fig. 11 is an enlarged sectional view, corresponding to Fig. 3, of a radio frequency identification tag according to another modification of the second embodiment.
Fig. 12 is an enlarged sectional view, corresponding to Fig. 3, of a radio frequency identification tag according to a third embodiment of the present invention.
Fig. 13 is an enlarged sectional view, corresponding to Fig. 3, of a radio frequency identification tag according to a modification of the third embodiment.
Fig. 14 is an enlarged sectional view, corresponding to Fig. 3, of a radio frequency identification tag according to another modification of the third embodiment.
Fig. 15 is an enlarged sectional view, corresponding to Fig. 3, of a radio frequency identification tag according to still another modification of the third embodiment.
Fig. 16 is a perspective view of a radio wave reflector according to a fourth embodiment of the present invention.
Fig. 17 is a perspective view of a radio wave reflector according to a modification of the fourth embodiment.
Fig. 18 is a perspective view of a radio wave reflector according to another modification of the fourth embodiment.

### BEST MODE FOR CARRYING OUT THE INVENTION

Description will be made below on the embodiment of the present invention with reference to the attached drawings.

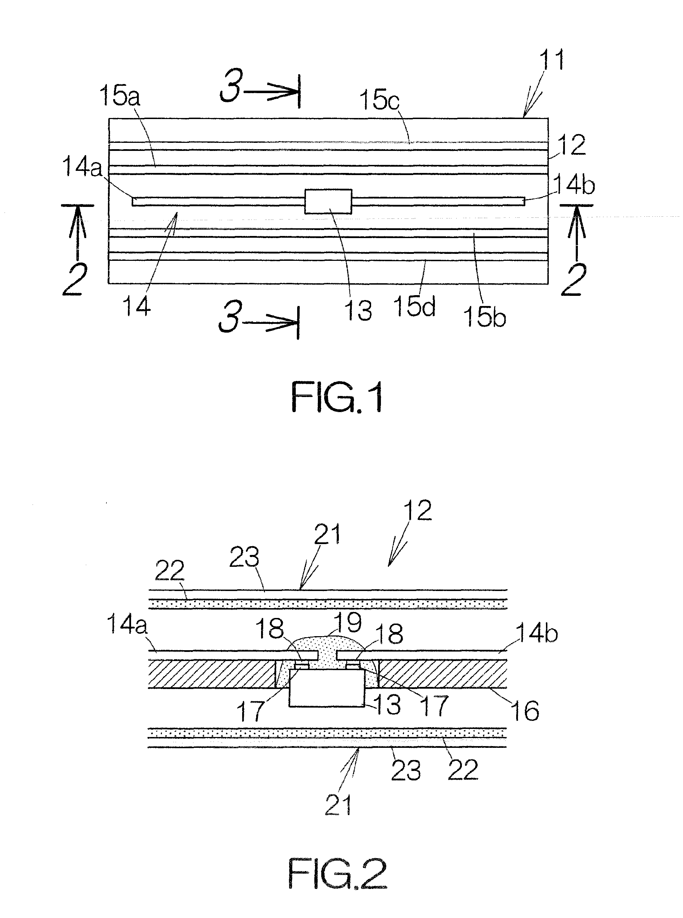

Fig. 1 schematically illustrates a radio frequency identification (RFID) tag according to a first embodiment of the present invention. The radio frequency identification tag 11 includes a thin plate 12 made of a resin material. A semiconductor chip 13 is embedded in the thin plate 12. A radio transmitting/receiving circuit, a logic circuit, a memory, and the like, are incorporated in the semiconductor chip 13, for example. Predetermined information data, for example, is stored in the memory.

An antenna device 14 is likewise embedded in the thin plate 12. The antenna device 14 includes a pair of antenna wires 14a, 14b forming a so-called dipole antenna. The antenna device 14 is connected to the semiconductor chip 13. The semiconductor chip 13 is designed to generate electric power in response to the reception of radio wave at the antenna device 14. The electric power enables a predetermined operation of the semiconductor chip 13. The information data in the memory, for example, can be transmitted from the antenna device 14.

A radio wave reflector 15 is also embedded in the thin plate 12. The radio wave reflector 15 is made of a metallic material such as iron, aluminum and copper. The radio wave reflector 15 includes elongated members 15a, 15b, 15c, 15d extending in parallel with the antenna wires 14a, 14b. The elongated members 15a-15d are distanced from each other. The elongated members 15a-15d will be described later in detail.

As shown in Fig. 2, the thin plate 12 includes a substrate 16 made of a resin material such as polyester or polyimide. The aforementioned semiconductor chip 13 is placed in an aperture defined in the substrate 16. A pair of electrically-conductive contacts 17 is formed on the semiconductor chip 13. The electrically-conductive contacts 17 are designed to receive one ends of the antenna wires 14a, 14b, respectively. Bumps 18 are utilized to bond the ends of the antenna wires 14a, 14b to the corresponding electrically-conductive contacts 17, respectively, for example. The antenna wires 14a, 14b are in this manner electrically connected to the semiconductor chip 13.

A sealant 19 covers over the semiconductor chip 13 on the substrate 16. The sealant 19 may be made of a resin material, for example. The substrate 16 is interposed between a pair of thin films 21, 21. The thin films 21 each include an inner adhesive material 22 and an outer coating material 23 placed at the outer surface of the adhesive material 22. The adhesive material 22 may be made of ethyl-vinyl acetate, butyral resin, silicone resin adhesive, or the like, for example. The coating material 2 3 may be made of polymer material having a high strength, such as polyester, polyimide, polyethylene, or the like. As is apparent from Fig. 1, for example, the semiconductor chip 13, the antenna device 14 and the radio wave reflector 15 are interposed between the thin films 21 adhered to each other. The semiconductor chip 13, the antenna device 14 and the radio wave reflector 15 are in this manner embedded in the thin plate 12.

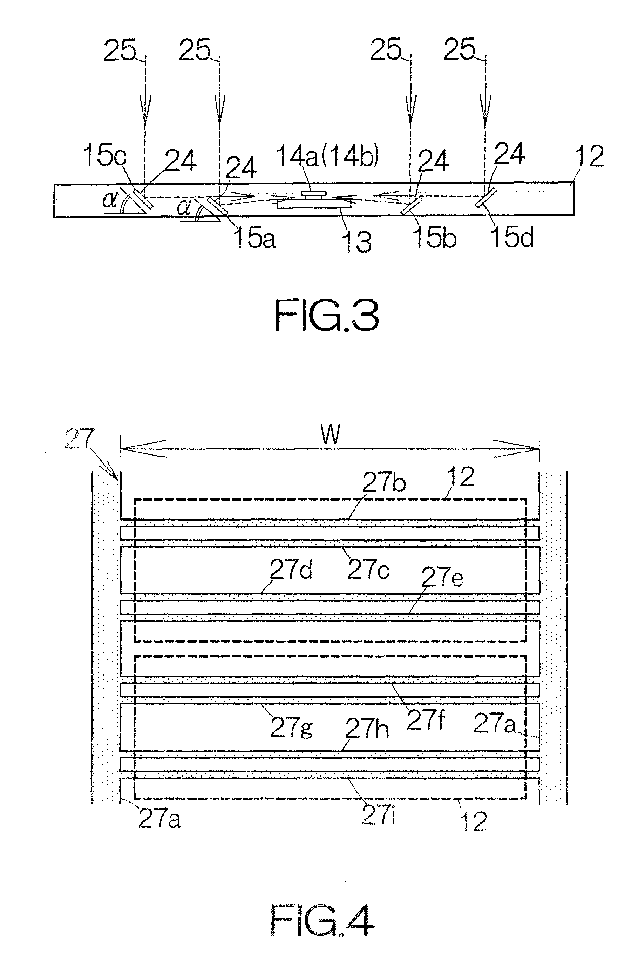

Fig. 3 schematically illustrates the radio wave reflector 15 according to the first embodiment of the present invention. The elongated members 15a, 15b, 15c, 15d each defines a flat surface 24 inclined by a predetermined inclination angle α around the rotation axis parallel to the antenna wires 14a, 14b. The inclination angle α allows the flat surface 24 to locate the outer ends, remoter from the antenna wires 14a, 14b, at a position closer to the front surface of the thin plate 12. The flat surface 24 extends over the entire length of the elongated member 15a-15d. The elongated member 15a-15d may have a uniform cross-section in the lengthwise direction. The inclination angle α may be determined depending on the expected incidence of radio wave 25 and the relative positions between the elongated members 15a-15b and the antenna wires 14a, 14b. As is apparent from Fig. 3, the radio frequency identification tag 11 allows the flat surface 24 to reflect radio wave 25 penetrating into the front surface of the thin plate 12. The reflected radio wave is directed to the antenna wires 14a, 14b. The radio wave reflector 15 serves to increase the received amount of the radio wave at the antenna wires 14a, 14b. The radio frequency identification tag 11 significantly contributes to increase of a communication range.

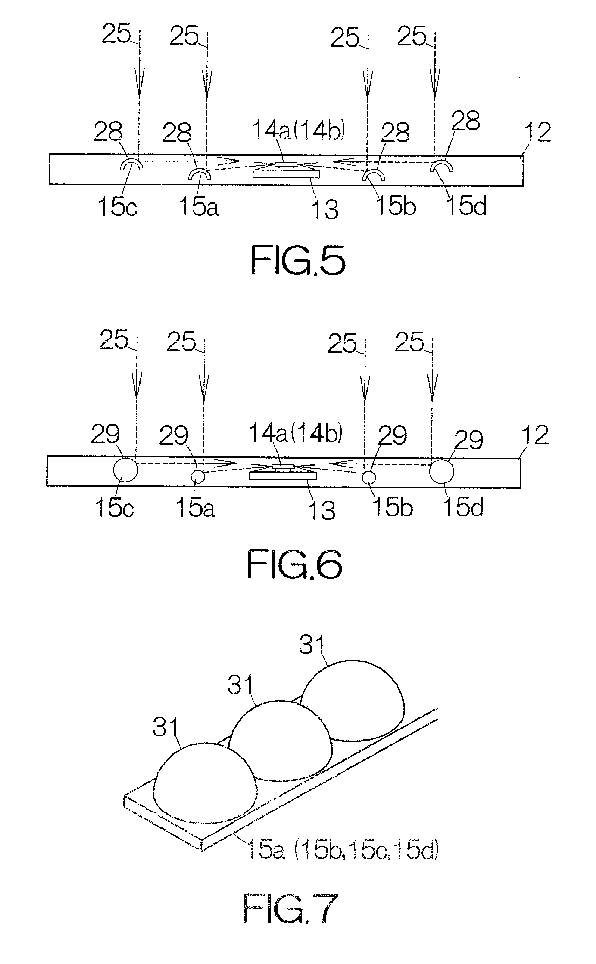

A brief description will now be made on a method of making the radio frequency identification tag 11. Here, as shown in Fig. 4, for example, an elongated metal thin plate 27 is prepared. The metal thin plate 27 includes a pair of support members 27a, 27a extending in the longitudinal direction of the metal thin plate 27. An interval *W* between the support members 27a is set larger than the entire lengths of the elongated members 15a-15d. Thin plate pieces 27b, 27c, ... are arranged in the longitudinal direction of the metal thin plate between the support members 27a, 27a. The arrangement of the thin plate pieces 27b, 27c, ... reflects the arrangement of the elongated members 15a-15d in the radio frequency identification tag 11. The support members 27a are bent between the thin plate members 27b so as to establish the inclination angle α of the corresponding elongated members 15a-15d.

The metal thin plate 27 is utilized to make the substrate 12, for example. The bent metal thin plate 27 is set in the cavity of a die, not shown. Injection molding is conducted, so that the metal thin plate 27 is included within a resin material in the cavity. The die is then cooled. The formed resin plate is taken out of the die. The substrate 12 is cut out of the resin plate. The substrate 12 may include the predetermined thin plate pieces 27b, 27c, .... The radio frequency identification tag 11 is formed based on the substrate 12. It should be noted that the radio frequency identification tag 11 may be made in any method different from the described one.

As shown in Fig. 5, for example, the radio frequency identification tag 11 may employ elongated members 15a, 15b, 15c, 15d each defining a semicylindrical surface 28 in place of the flat surface 24. The semicylindrical surface 28 has the generatrix parallel to the antenna wires 14a, 14b. The semicylindrical surface 28 may extend over the entire length of the elongated member 15a-15d. The elongated member 15a, 15b, 15c, 15d may have a uniform cross-section in the lengthwise direction.

Here, the semicylindrical surfaces 28 are opposed to a plane including the front surface of the thin plate 12. The semicylindrical surfaces 28 thus serve to reflect the radio wave 25 penetrating into the front surface of the thin plate 12. The reflected radio wave is directed to the antenna wires 14a 14b. The radio wave reflector 15 serves to increase the received amount of the radio wave at the antenna wires 14a, 14b. The radio frequency identification tag 11 significantly contributes to increase of a communication range. It should be noted that the semicylindrical surface 28 may have the cross-section contoured along a circle, an oval, or the like, for example.

As shown in Fig. 6, for example, the radio frequency identification tag 11 may employ elongated members 15a, 15b, 15c, 15d each defining a cylindrical surface 29 in place of the flat surface 24 and the semicylindrical surface 28. The cylindrical surface 29 has the generatrix parallel to the antenna wires 14a, 14b. The cylindrical surface 29 may extend over the entire length of the elongated member 15a-15d. The elongated member 15a, 15b, 15c, 15d may have a uniform cross-section in the lengthwise direction. The radio frequency identification tag 11 can achieve the advantages identical to those obtained in the aforementioned radio frequency identification tags 11. It should be noted that the cylindrical surface 29 may have a cross-section contoured along a circle, an oval, or the like, for example.

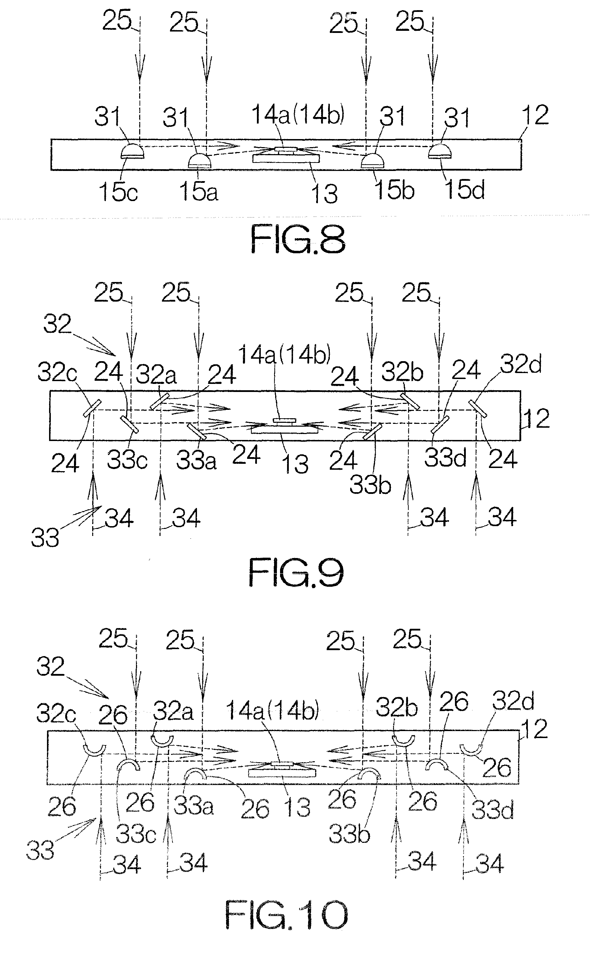

As shown in Fig. 7, the radio frequency identification tag 11 may employ elongated members 15a, 15b, 15c, 15d including domed or semispherical surfaces 31, for example. The domed surfaces 31 may be arranged over the entire length of the elongated member 15a-15d. As is apparent from Fig. 8, for example, the radio frequency identification tag 11 can achieve the advantages identical to those obtained in the aforementioned radio frequency identification tags 11.

Fig. 9 schematically illustrates a radio wave reflector 15 according to a second embodiment of the present invention. The radio wave reflector 15 includes a first elongated member set 32 disposed along the front surface of the thin plate 12, and a second elongated member set 33 disposed along the back surface of the thin plate 12. The first and second elongated member sets 32, 33 includes elongated members 32a, 32b, 32c 32d, 33a, 33b, 33c, 33d each having the structure identical to that of the aforementioned elongated member 15a-15d. Here, the first elongated member set 32 includes the first elongated members 32a, 32b, 32c, 32d each defining the flat surface 24. In this case, the flat surface 24 is designed to locate the end, remoter from the antenna wires 14a, 14b, at a position closer to the back surface of the thin plate 12. The second elongated member set 33 likewise includes the second elongated members 33a, 33b, 33c, 33d each defining the flat surface 24. The flat surface 24 is designed to locate the end, remoter from the antenna wires 14a, 14b, at a position closer to the front surface of the thin plate 12. The flat surfaces 24 of the second elongated members 33a-33d serve to reflect radio wave 25 penetrating into the front surface of the thin plate 12. The reflected radio wave is directed to the antenna wires 14a, 14b. The flat surfaces 24 of the first elongated members 32a-32d serve to reflect radio wave 34 penetrating into the back surface of the thin plate 12. The reflected radio wave is directed to the antenna wires 14a, 14b. The radio wave reflector 15 serves to increase the received amount of the radio wave in the opposite directions at the antenna wires 14a, 14b.

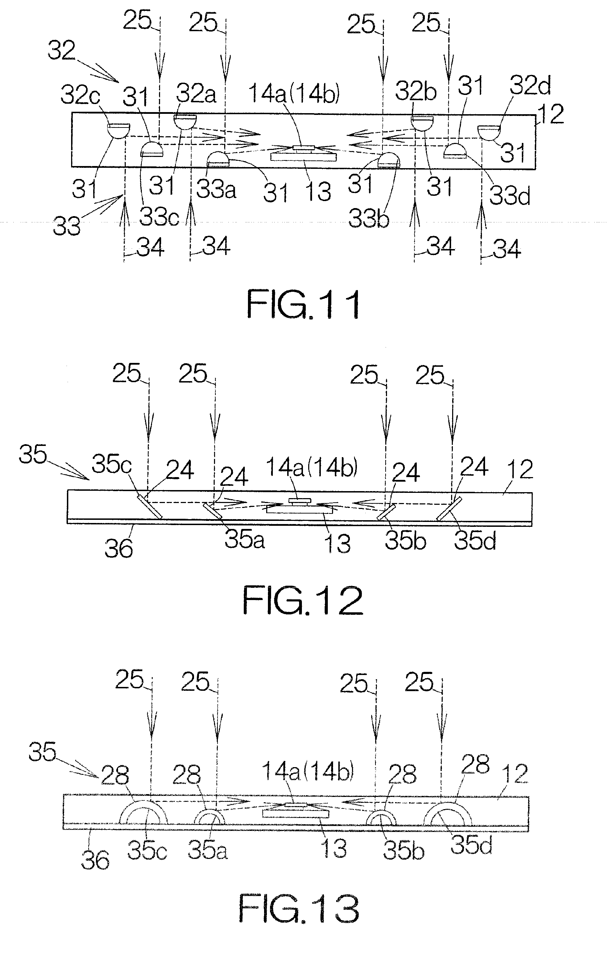

As shown in Figs. 10 and 11, for example, the radio frequency identification tag 11 may employ the elongated members 32a, 32b, 32c, 32d, 33a, 33b, 33c, 33d each defining the semicylindrical surface 26 or the domed surfaces 31 in place of the flat surface 24 in the same manner as the aforementioned elongated members 15a-15d. In this case, the first elongated member set 32 may include the first elongated members 32a-32d having the semicylindrical surfaces 26 or the domed surfaces 31 opposed to a plane including the back surface of the thin plate 12. The second elongated member set 33 may include the second elongated members 33a-33d having the semicylindrical surfaces 26 or the domed surfaces 31 opposed to a plane including the front surface of the thin plate 12.

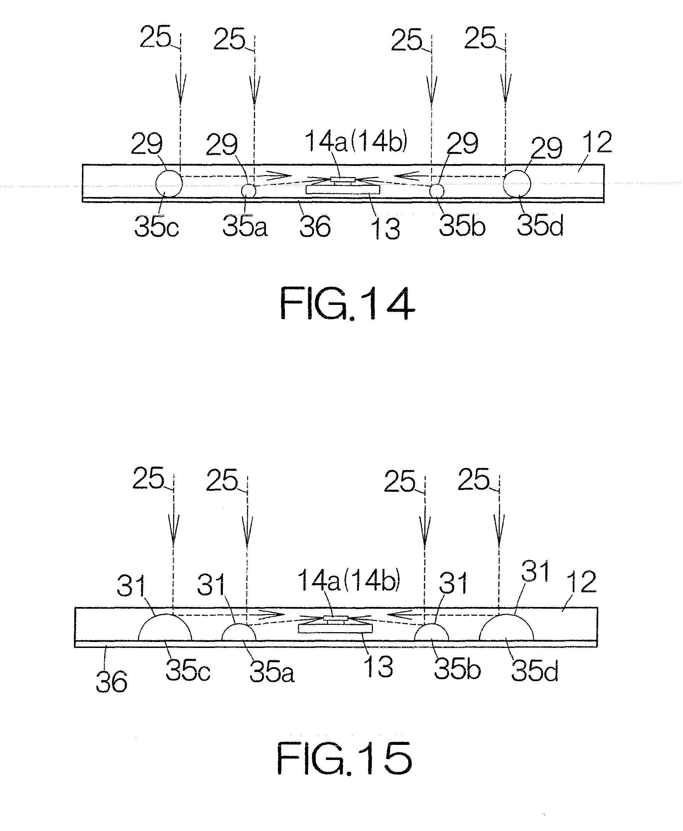

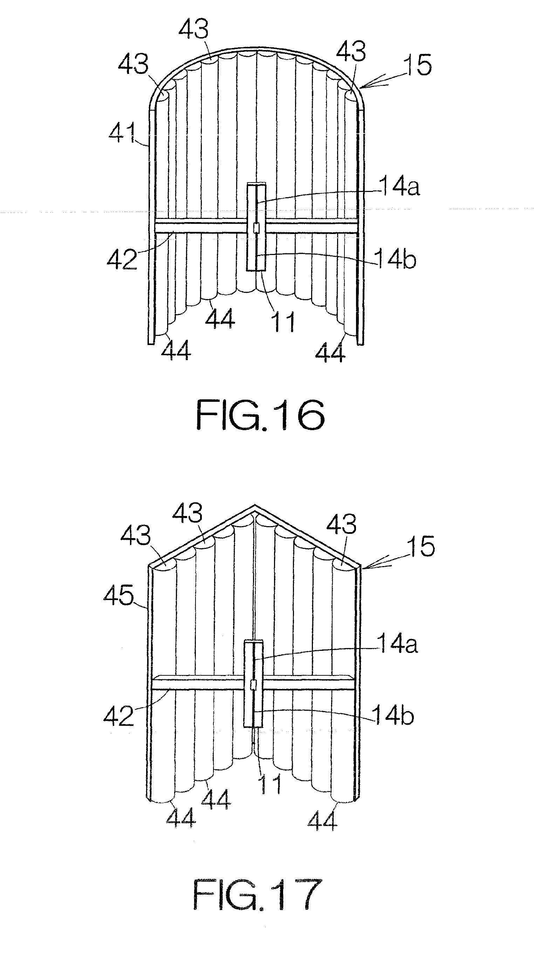

Fig. 12 illustrates a radio wave reflector 15 according to a third embodiment of the present invention. The radio wave reflector 15 includes an elongated member set 35 disposed along the back surface of the thin plate 12. A shielding plate 36 made of metal is bonded to the back surface of the thin plate 12. The elongated member set 35 includes elongated members 35a, 35b, 35c, 35d each having the structure identical to that of the aforementioned elongated members 15a-15d. Here, the elongated members 35a, 35b, 35c, 35d may each define the flat surface 24 designed to locate the end, remoter from the antenna wires 14a, 14b, at a position closer to the front surface of the thin plate 12. Since the shielding plate 36 is attached to the back surface of the thin plate 12 in the radio frequency identification tag 11, the antenna wires 14a, 14b are allowed to always receive radio wave of a sufficient intensity whatever contacts with the back surface of the thin plate 12. The elongated members 35a, 35b, 35c, 35d may each define the semicylindrical surface 28, as shown in Fig. 13, the cylindrical surface 29, as shown in Fig. 14, or the domed surfaces 31, as shown in Fig. 15, in place of the flat surface 24 in the same manner as described above.

Fig. 16 schematically illustrates a radio wave reflector 15 according to a fourth embodiment of the present invention. The radio wave reflector 15 includes a reflective plate 41 surrounding an imaginary semicylindrical space at a position outside the radio frequency identification tag 11. The antenna wires 14a, 14b of the radio frequency identification tag 11 extend along the longitudinal axis of the imaginary semicylindrical space. The radio frequency identification tag 11 is bonded to a support member 42. The support member 42 is fixed to the reflective plate 41.

Elongated members 43 are fixed to the inward surface of the reflective plate 41. The elongated members 43 extend in parallel with the longitudinal axis of the imaginary semicylindrical space. The elongated members 32 each define a semicylindrical surface 44 having the generatrix parallel to the longitudinal axis of the imaginary semicylindrical space. The semicylindrical surface 44 may extend over the entire length of the elongated member 43. The elongated members 43 may each have a uniform cross-section in the lengthwise direction.

The reflective plate 41 serves to direct radio wave toward the antenna wires 14a, 14b. The antenna wires 14a, 14b are allowed to receive radio wave of an increased amount. In addition, the semicylindrical surfaces 44 serve to reliably direct radio wave from all directions toward the antenna wires 14a, 14b. The radio frequency identification tag 11 significantly contributes to increase of a communication range. It should be noted that the radio wave reflector 15 may employ rows of the domed surfaces 31, 31, ... in place of the elongated members 43.

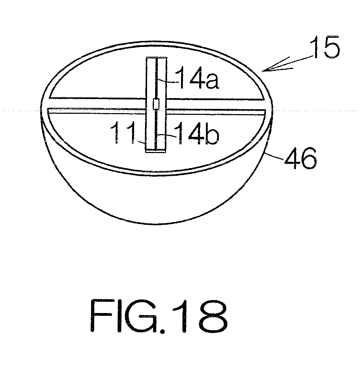

As shown in Fig. 17, for example, the radio wave reflector 15 may employ a reflective plate 45 including two flat plates in place of the reflective plate 41 surrounding the imaginary semicylindrical space. In this case, the semicylindrical surfaces 44, 44, ... may be arranged in parallel with the antenna wires 14a, 14b in the same manner as described above. It should be noted that rows of the domed surfaces 31, 31, ... may be employed in place of the semicylindrical surfaces 44 in the same manner as described above. As shown in Fig. 18, the ratio wave reflector 15 may utilize a reflective plate 46 surrounding a semispherical space, for example. In this case, the domed surfaces 31, 31, ... may be packed on the inward surface of the reflective plate.

## Claims

1. A radio frequency identification tag comprising:
a thin plate made of a resin material;
an antenna wire embedded in the thin plate; and
a radio wave reflector made of a metallic material embedded in the thin plate, the radio wave reflector extending in parallel with the antenna wire.

2. The radio frequency identification tag according to claim 1, wherein the antenna wire forms a dipole antenna or a folded dipole antenna.

3. The radio frequency identification tag according to claim 1, wherein the radio wave reflector includes elongated members spaced from each other, the elongated members each defining a flat surface inclined by a predetermined inclination angle around a rotation axis parallel to the antenna wire.

4. The radio frequency identification tag according to claim 3, wherein the elongated members includes:
a first elongated member set comprising first elongated members disposed along a front surface of the thin plate, the first elongated members each having one end remoter from the antenna wire and located closer to a back surface of the thin plate; and
a second elongated member set comprising second elongated members disposed along the back surface of the thin plate, the second elongated members each having one end remoter from the antenna wire and located closer to the front surface of the thin plate.

5. The radio frequency identification tag according to claim 3, wherein the elongated members include an elongated member set comprising specific elongated members disposed along a back surface of the thin plate, the specific elongated members each having one end remoter from the antenna wire and located closer to a front surface of the thin plate.

6. The radio frequency identification tag according to claim 1, wherein the radio wave reflector includes elongated members spaced from each other, the elongated members each defining a semicylindrical surface having generatrix parallel to the antenna wire.

7. The radio frequency identification tag according to claim 6, wherein the elongated members includes:
a first elongated member set comprising first elongated members disposed along a front surface of the thin plate, the first elongated members each defining a semicylindrical surface opposed to a back surface of the thin plate; and
a second elongated member set comprising second elongated members disposed along the back surface of the thin plate, the second elongated members each defining a semicylindrical surface opposed to the front surface of the thin plate.

8. The radio frequency identification tag according to claim 6, wherein the elongated members include an elongated member set comprising specific elongated members disposed along a front surface of the thin plate, the specific elongated members each defining a semicylindrical surface opposed to a back surface of the thin plate.

9. The radio frequency identification tag according to claim 1, wherein the radio wave reflector includes elongated members spaced from each other, the elongated members each defining a cylindrical surface having generatrix parallel to the antenna wire.

10. The radio frequency identification tag according to claim 1, wherein the radio wave reflector includes elongated members each defining domed surfaces arranged in parallel with the antenna wire.
